# EUROPEAN PATENT APPLICATION

(11) **EP 2 584 364 A1**
(43) Date of publication of application: **24.04.2013**
(21) Application number: 11185788.4
(22) Date of filing: 19.10.2011
(51) Int. Cl.: G01R 15/18, G01R 15/20, G01R 15/24, G01R 15/14

(54) **Self centering, split multicore current sensor**

(71) Applicant: Raychem International, Co. Clare (IE)
(72) Inventor: O'Sullivan, Michael, Ennis, County Clare (IE); O'Toole, Thomas, Ennis, County Clare (IE)
(74) Representative: Grünecker, Kinkeldey, Stockmair & Schwanhäusser

(57) **Abstract**

The present invention relates to sensor devices, in particular to those which are adapted to be attached to cables. Furthermore, the present invention relates to a method for fabricating such a sensor device. The sensor device (100) for being attached to a cable to be monitored comprises at least one sensor element (104), and a housing (102) which at least partly encases said at least one sensor element (104) and which is configured to encompass the cable during a measurement process, wherein said housing (102) is fabricated as a single part from a resilient electrically insulating material and is elastically deformable to be mounted at said cable.

## Description

The present invention relates to sensor devices, in particular to those which are adapted to be attached to cables. Furthermore, the present invention relates to a method for fabricating such a sensor device.

In particular, in the field of fault current measurement, metering applications or any other AC current measuring application, sensor devices are needed which can be attached to the cable in a way that the position of a sensor element is defined such that it enables maximum accuracy of the measurement. Although in the following mostly electrically conductive cables are considered as objects to be monitored, the principles of the present invention may also be applied to all sorts of conducts for gases and liquid fluids or to optical fibers.

Depending on the particular characteristics of the measurement object, such as electrical current flowing therein, temperature, magnetic field or mechanical vibrations, the type of sensor element which is contained in the sensor device according to the present invention, can be different. Further, also a plurality of sensor types may be incorporated within the housing according to the present invention. In the following, as an example mostly, an application as a current sensor is envisaged.

As for instance explained in great detail in US 7,321,226 B2, a variety of current measurement techniques are known in the art, including current transformers, Rogowski coil transformers, resistive shunts in series or in parallel with a current carrying conductor, magnetic field point sensors, magnetic field line integral sensors, and line integral optical current sensors.

Current transformers consist of two or more windings, each winding consisting of one or more turns of wire, around a continuous core having a high magnetic permeability to concentrate the magnetic flux lines generated by current flowing in the windings. The ratio of turns in the windings determines the turns ratio of the transformer. Clamp-on current transformers introduce a break in the core to permit its installation around a current carrying conductor without breaking the conductor. Current transformers only respond to AC currents unless special steps are taken to actively switch the magnetization direction or strength in the core. Furthermore, at high voltages found in power transmission systems, current transformers become extremely large and heavy and contain insulating mineral oil in order to satisfy the dielectric requirements of the application.

A Rogowski coil consists of a coil winding placed around a core having a magnetic permeability similar to air. A current-carrying conductor is passed through the coil, and generates an output voltage that is proportional to the time derivative of the current in the conductor. The real-time current can be estimated by time-integrating the signal from the Rogowski coil. Rogoswki coils require an AC current to generate an output signal, and their output amplitude is proportional to the frequency, amplitude and differential of the current.

A resistive shunt consists of a resistor connected to a current-carrying conductor in such a manner as to allow at least some of the conductor current to pass through the resistive element. The resulting voltage drop across the resistive element is a measure of the current flowing through the element. The resistive element can be placed in series with the current-carrying conductor, whereby all the conductor current passes through the resistive element, or it can be placed in parallel with a portion of the current-carrying conductor, whereby it shunts a known portion of the current away from the conductor. Resistive current sensors can measure AC or DC currents, and are relatively easy to use when the currents to be measured are small, i.e. less than 100 Amperes.

Field sensors take advantage of the magnetic field generated by the current in a conductor. By placing a point magnetic field sensor such as a Hall sensor near the conductor, the sensor output signal is proportional to the current in the conductor. By using a magnetic field sensor of the proper type, this current sensor can respond to AC or DC currents, and can have a wide frequency response. Calibration is difficult to achieve or maintain with this approach. Stray magnetic fields generated by other currents located nearby will also cause measurement errors.

Optical current sensors use the Faraday effect in an optical solid to change the travel time, polarization state or optical phase of an optical signal, in direct proportion to the magnetic field present along the optical path. By creating a closed optical path that encircles a current carrying conductor, the resulting signal is proportional to the current, and is substantially immune to interfering magnetic fields from other conductors, the position of the conductor relative to the sensor structure, and the size of the conductor. The sensor can be made to respond to DC or AC currents, and it can have a high bandwidth. Optical current sensors are difficult to design as a clamp-on device, and they suffer from high costs.

The most accurate current sensors take advantage of Ampere's law, which states that the line integral of the magnetic field along a closed path encircling a current is proportional to the current. More importantly, the integral is not sensitive to the details of the path shape, the spatial distribution of the current within the closed integration path, or the presence of any currents that do not pass through the closed integration path. The current transformer achieves this by having a closed path of high permeability core. The Rogowski coil achieves this by having a coil encircling the conductor with uniform turns per inch along the winding. The optical current sensor achieves this by having an optical sensor element encircling the conductor, such as a block of glass through which a hole has been machined to allow a conductor to pass through and in which the optical beam propagates in a closed path encircling the hole, or an optical fiber that carries the optical signal and can be formed into a closed loop or loops around the current carrying conductor.

Current sensors that rely on one or two point magnetic field sensors do not approach a good approximation of Ampere's law, and are therefore prone to inaccuracies due to the presence of external magnetic fields and the position of the conductor relative to the sensor(s).

Most of the sensor principles discussed in US 7,321,226 B2 can be combined with the inventive flexible housing according to the present invention, provided that the sensor element does not hinder the elastic deformation of the housing or is damaged by the movement.

Furthermore, clamp-on and slipover current sensors have been previously disclosed and are well known in the art. However, there has always been the necessity of providing complicated and expensive hinges and fastening means.

The power utility industry measures current and voltage to calculate power flow and energy transferred between suppliers and customers. There are several standards defined by the Institute for Electrical and Electronics Engineers (IEEE) and the International Electricity Committee (IEC) that determine the magnitude and phase angle accuracy requirements for devices used to measure current when used for revenue metering or system protection. For example, ANSI/IEEE Standard C57.13 requires that a current transformer must have an amplitude error of no greater than +/-0.3% and a phase angle error of no greater than +/-15 minutes of arc over a wide range of currents, regardless of temperature, stray magnetic fields, conductor size or installation environment. IEC Standard 60044-7 has a similar current transformer requirement of +/-0.2% magnitude error and +/-10 minutes of arc in phase angle error. The only current sensors that can meet these requirements must either replicate or closely mimic Ampere's law. The prior art current sensors mentioned in US 7,321,226 B2 that use one or a few point magnetic field sensors cannot meet these stringent accuracy requirements, and generally have magnitude accuracies that fall in the range of 1%-20%. Magnetic field sensors such as Hall sensors and Magneto-resistive sensors are notoriously inaccurate in conditions as wide-ranging as -50 degrees C. to +85 degrees C., time spans of a decade, large fault currents of >100,000 Amperes, or when subjected to mechanical stress.

Furthermore, from US 6,825,650 B1, it is known to form a current probe from a series of Rogowski coils equally spaced around the circumference of a circle, with a gap between two adjacent coils, permitting the current carrying conductor to be introduced into the loop.

However, there still exists a need for a sensor device that can ensure a high accuracy, is light-weight, low-cost and can be clamped in place without having to disconnect the conductor or conduit being monitored.

The present invention is based on the idea of embedding sensor elements within a housing fabricated from a flexible material that is formed as one integral single part. In particular, the housing encases the sensor element and can be clamped onto the cable during a measurement process. For mounting the sensor device to the cable to be monitored, same is elastically deformed.

The advantage of this idea firstly lies in the fact that the installation is facilitated and the sensor elements are securely protected from moisture and physical damage.

According to an advantageous embodiment, the sensor element comprises at least one current measurement device which can accurately measure the current in an electrical conductor without cutting or breaking the conductor.

Alternatively or additionally to the current sensor, the sensor device according to the present invention may also comprise a voltage measurement device. Such a voltage sensor may advantageously provide further information on the electrical condition of the cable to be monitored. The voltage sensor can for instance comprise a voltage plate which is in direct contact with a semiconductor layer of the cable, the so-called semicon material. The voltage plate will sense the voltage in the internal conductor of the cable to be monitored and this signal will give a differential signal when compared with the ground plane. Part of such a voltage sensor can also be embedded in a stress relieve mechanism which forms part of a switch gear connection system, such as the RSTI product line of TE connectivity.

In order to maintain a precise geometrical relationship between the sensor element and the cable to be monitored, the housing is formed by overmolding the sensor element directly. A variety of materials can be used for this overmolding step, such as polyvinyl chloride (PVC), silicone, rubber, neoprene, nitryl, ethylene propylene diene monomer (EPDM) rubber, or polyurethane.

The housing may either be configured as a simple sensor probe, therefore containing only the sensor elements and optionally some signal pre-processing element, transmitting the measured signals to the outside by means of wireless techniques or electrically conductive leads. Alternatively, the required intelligence for evaluating the measured signals and display or warning devices of some sort may also be directly integrated within the housing. Fault current sensors may for instance contain an acoustic and/or optic warning device and may be fabricated with at least a part of the housing being transparent.

It is known in particular for Rogowski coils that an accurate centering of the cable to be monitored with respect to the coils is essential for achieving a particularly accurate measurement. Thus, a centro-symmetric form of the housing is advantageous. This may for instance be achieved by providing a ring-shaped sensor portion at the housing which accommodates the at least one sensor element. When using a substantially circular cross-section for the housing and providing at least one mounting sleeve for fixing the sensor device at the cable, a secure centering of the housing with the embedded sensors with respect to the cable to be monitored can be achieved.

In order to allow a mounting of the sensor device at the cable in a direction across to the longitudinal axis of the cable, thus dispensing with the need of cutting or loosening the cable, the housing is provided with a slit-shaped opening that leaves in a radial direction an unobstructed gap for mounting the mounting sleeve on the cable. The mounting sleeve may have an inner surface which is either smooth or provided with radial or axial waves or protrusions, as this is known from rubber grommets. In order to adapt the sensor device to a particularly large range of cable diameters, at the mounting sleeve at least one resilient protrusion may be provided for adapting the inner cross-sectional dimension of the mounting sleeve to varying outer crossectional dimensions of the cable to be monitored. According to an advantageous embodiment, the ring-shaped sensor portion is connected via at least one bellows-shaped connection portion to such a mounting sleeve. In particular, by providing two mounting sleeves which are distanced from each other in a longitudinal direction, and each fixed at the ring-shaped sensor portion by means of a bellows-shaped connection portion, a particularly stable and robust sensor device can be achieved. The packaging technique according to the present invention can be applied to all sorts of sensors which should be mounted in a pre-defined geometric relation to a cable or fluid conduit.

When mounting the sensor device at the cable to be monitored, the housing has to be deformed elastically, for instance by opening a crossection which is formed as a broken circle. In order to ensure that such a mounting step does not damage the sensor elements encapsulated within the housing, same are preferably implemented as a plurality of radio frequency (RF) choke coils which are connected to each other by means of flexible wires or flexible circuit boards.

For instance, the choke coils can be connected in series, as shown in US 6,825,650 B1.

In order to reduce undesired electromagnetic interferences, an electrically conductive shielding element, for instance a braided tubular shield, can be provided around the RF chokes connected in series.

A terminal portion of the sensor device may be located in the same region or diagonally opposing region as the slit-shaped opening provided at the housing. The sensor device maintains equidistance between each RF chokes after installation on the cable especially in relation to the RF chokes on either side of the slit.

Furthermore, identification means, such as coded resistors, may be introduced into the sensor device for providing an electronically readable identification means of the sensor device.

According to a further advantageous embodiment, the sensor device has an embedded electronic circuitry which is encased within the housing. This allows a compact sensor design with an enhanced functionality and accuracy, because no additional leads have to be provided for transporting the signals from the sensor elements to the necessary electronic circuitry. Furthermore, in outdoor applications or rough environments, the electronic circuitry is securely protected from dust and intrusion of water.

The electronic circuit may comprise an integrator circuit and/or a circuit carrier with a complete signal processing unit. In particular, the electrical output signal from the RF chokes is a derivative of the current with respect to the time (di/dt). In order to recover the actual current wave form of the current flowing through the cable to be monitored, the signal can be passed through an electronic integration circuit, which may be powered externally. According to the present invention, the electronic circuitry can be embedded into the molding compound such that the output signal is a true current wave form.

Furthermore, the entire electronics required to measure and process the sensed current and/or voltage can be overmolded into the sensor device according to the present invention. For instance, a printed circuit board, PCB, can be provided which carries the processing electronics and can be embedded within the housing. A display unit, such as a liquid crystal display, LCD, and/or a plurality of light-emitting diodes, LED, can be provided for indicating a status of the sensor device.

By embedding optical indicators, such as LEDs, with differing colours to illuminate through the resin, e.g. polyurethane, a visual indicator can be given to an observer of the amount of current passing through the conductor. For instance, the LEDs can be controlled in response to the measured current in a way that no colour means no current, green colour means rated current, amber colour signifies high current and red colour indicates an excessive current. Furthermore, a flashing red LED signal could be used in order to indicate a fault condition existing on the cable. The LEDs can be made visible for an operator either by providing windows near the LEDs or by using a transparent material for the complete housing.

According to a further embodiment, the sensor device may comprise energy harvesting means which are able to harvest energy from the conductor, whereto the sensor is attached. For instance, energy harvesting coils can be embedded into the housing, for instance a polyurethane resin, in order to harvest power from the cable being monitored. Two flux concentrated type electronic units may be incorporated for harvesting the necessary power from the conductor and, furthermore, a storage device may also be included in the sensor device. Such an energy storage unit may be in the form of a battery, a super capacitor, or both. Thus, a compact stand-alone sensor unit can be provided, which does not have to rely on additional energy sources.

The accompanying drawings are incorporating into and form a part of the specification to illustrate several embodiments of the present invention. These drawings together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. Further features and advantages will become apparent from the following more particular description of the various embodiments of the invention, as illustrated in the accompanying drawings, in which like references refer to like elements, and wherein:
- **FIG. 1**: is a perspective view of a sensor device according to a first embodiment;
- **FIG. 2**: is a sectional view of the sensor device of FIG. 1;
- **FIG. 3**: is a detail of FIG. 2;
- **FIG. 4**: is a top view of the sensor device of FIG. 1;
- **FIG. 5**: is a lateral view of the sensor device according to FIG. 1;
- **FIG. 6**: is a perspective view of a sensor device according to a second advantageous embodiment;
- **FIG. 7**: is a sectional view of the sensor device of FIG. 6;
- **FIG. 8**: is a lateral view of the sensor device of FIG. 6;
- **FIG. 9**: is a cut along the lines shown in FIG. 7;
- **FIG. 10**: is a detail of FIG. 9;
- **FIG. 11**: is a schematic view of a sensor device according to a third embodiment;
- **FIG. 12**: shows a top view of a sensor device according to a further advantageous embodiment;
- **FIG. 13**: is a top view of a sensor device according to still a further advantageous embodiment;
- **FIG. 14**: is a top view of a sensor device according to another advantageous embodiment;
- **FIG. 15**: is a side view of the sensor device shown in FIG. 14;
- **FIG. 16**: is a sectional view of a sensor device comprising energy harvesting means;
- **FIG. 17**: is a top view of the sensor device shown in FIG. 16;
- **FIG. 18**: is a top view of the sensor device according to the first embodiment for explaining the geometric arrangement of the coil;
- **FIG. 19**: is a schematic top view of the sensor device according to a further advantageous embodiment;
- **FIG. 20**: is a perspective schematic view of a cable with a voltage sensing device attached thereto;
- **FIG. 21**: is a partly opened perspective view of a sensor device comprising a voltage sensor;
- **FIG. 22**: is a sectional view of a voltage sensing device which can be used together with the sensor device according to the present invention.

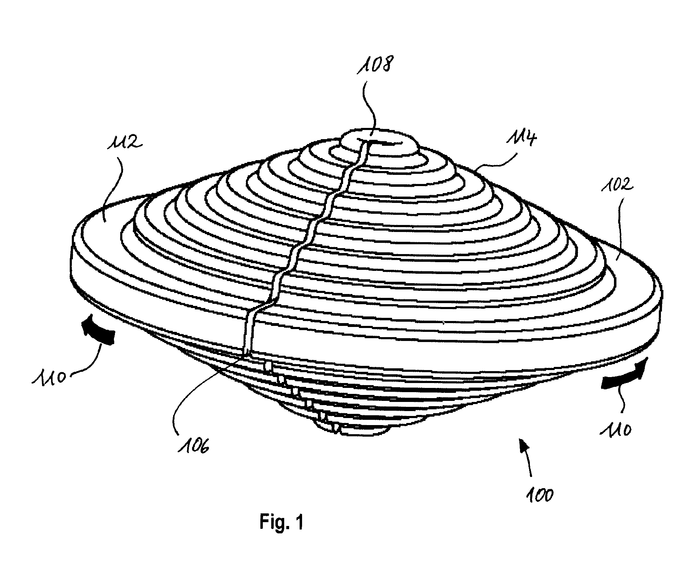

FIG. 1 shows in a perspective view a sensor device 100 according to a first embodiment of the present invention. The shown sensor device is a current measurement device which can be mounted directly on a cable without disconnecting same. To this end, the sensor device 100 has a housing 102 which is formed as one single molded part from a flexible material. For fixing the sensor device 100 on a cable (not shown in the figures), two mounting sleeves 108 are provided, which encompass the cable in a way like a grommet would do, with the difference that the radial circumference is not closed.

According to the present invention, the cable does not have to be slipped into the sensor device 100 and the mounting sleeves 108 in a longitudinal direction, but the sensor device 100 may be mounted in a direction across to the cable, due to the fact that a slit-shaped opening 106 is provided. Due to the fact that the housing material is flexible, the sensor device 100 may be opened-as indicated by arrows 110-wide enough to be mounted on the cable and will be clamped on the cable when releasing same.

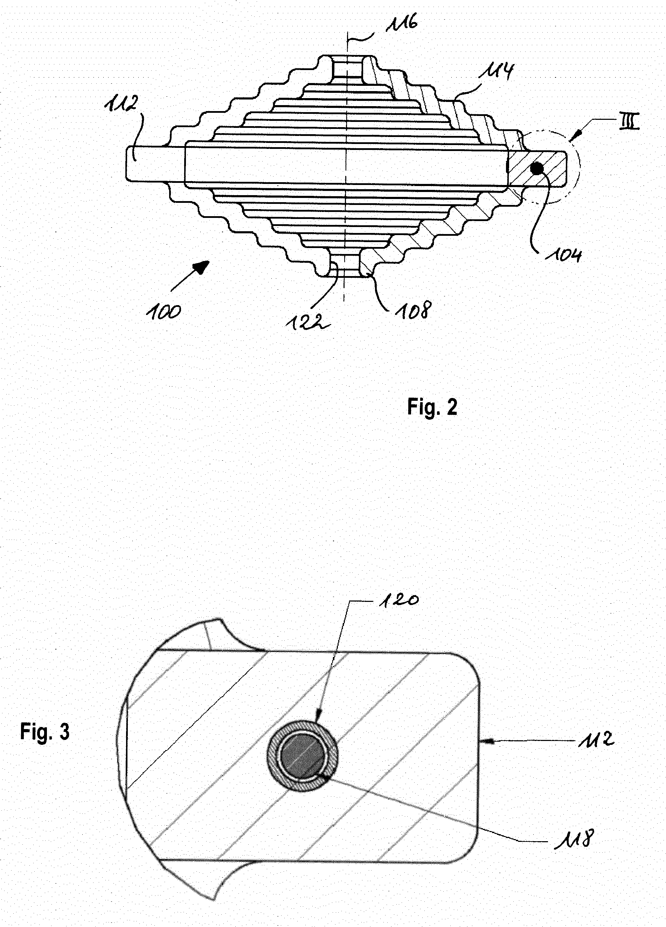

As will be apparent from the FIGs. 2 and 3, the ring-shaped sensor portion 112 encapsulates one or more sensor elements. In the case of an AC current sensor, this can be a plurality of RF chokes. Alternatively or additionally, also temperature sensors can be encapsulated in the housing material. In particular, the temperature sensors do not necessarily have to be located only in the sensor portion 112, but can also be arranged in direct contact with the cable, i. e. nearer to or directly within the mounting sleeves 108.

For providing a high mechanical flexibility and ensuring an accurate centering of the sensor portion 112 with respect to the center of the cable, a bellows-shaped connection portion 114 is provided between each of the mounting sleeves 108 and the sensor portion 112. The two connection portions 114 also can adjust for slight mounting tolerances in a longitudinal direction, when the sensor device is attached to the cable. The sensor elements which are embedded in the housing material 102 are thus accurately centered with respect to the cable to be monitored, as well as hermetically sealed against humidity, dust and physical damage.

By way of example, the sensor device may have an inner diameter of the mounting sleeves 108 of about 10 mm, an outer diameter of the sensor portion 112 of 150 mm and an inner diameter of the sensor portion of about 110 mm. The complete longitudinal outer dimension may amount to 76 mm from one mounting sleeve to the other. However, of course also other dimensions can be chosen, depending on the dimensions of the cable or conduit whereto the sensor device 100 has to be mounted.

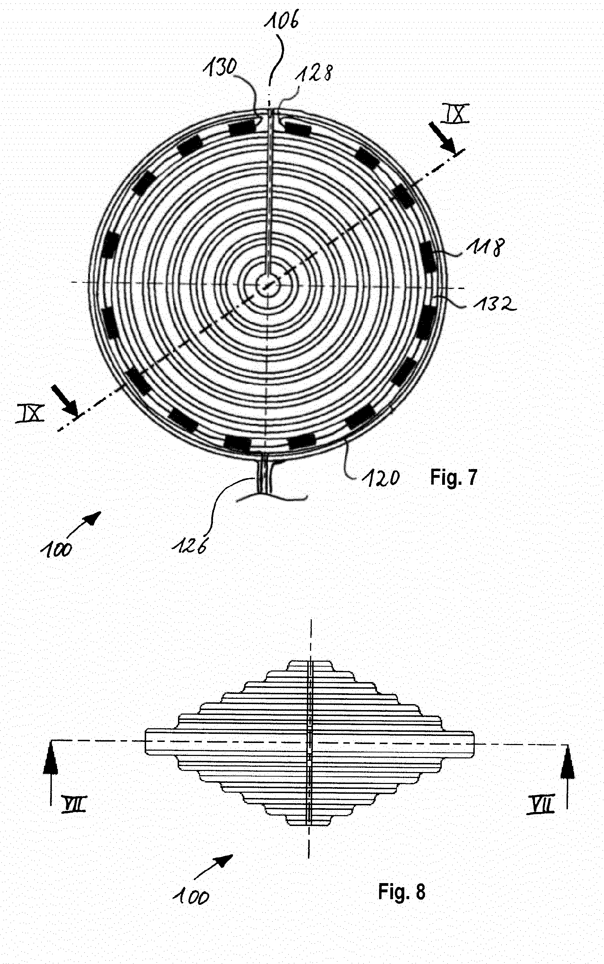

FIGs. 2 and 3 show a longitudinal sectional view of the sensor device 100 of FIG. 8 and a detail of the sensor portion 112. As may be derived therefrom, the sensor portion 112 is formed like a circular ring being centered with respect to the middle axis 116. By means of the slit 106 the housing 102 may be opened wide enough to attach the sensor device 100 to a cable, such that the central axis of the cable (not shown in the figure) coincides with the middle axis 116 of the sensor device 100. To this end, it is necessary that the sensor element 104 is either small enough or in itself flexible enough to follow this deformation. As shown in FIG. 3, the sensor portion may encapsulate a plurality of serially connected RF chokes 118, which are surrounded by a shielding 120. In this case, the connecting wires between the individual chokes provide the necessary flexibility for opening the sensor device 100 when mounting same on a cable. However, the sensor elements 104 may also be formed by one single Rogowski coil, by evenly distributed Hall sensor elements, capacitive sensing elements, or other sensor elements.

As shown in FIG. 2, the mounting sleeves 108 have a smooth inner surface 122 which attaches the sensor device 100 to the outer surface of a cable (not shown in the figures). However, it is clear for a person skilled in the art that the inner surface 122 may also have a different shape, for instance by providing longitudinal protrusions or radial ring-shaped protrusions, as this is known from grommets.

The connection regions between the sensor portion 112 and the mounting sleeves 108, respectively, are formed with a step-wise decreasing diameter in order to form a flexible bellows-shaped connection portion 114. If necessary, the transition between the two diameters may of course also be linear.

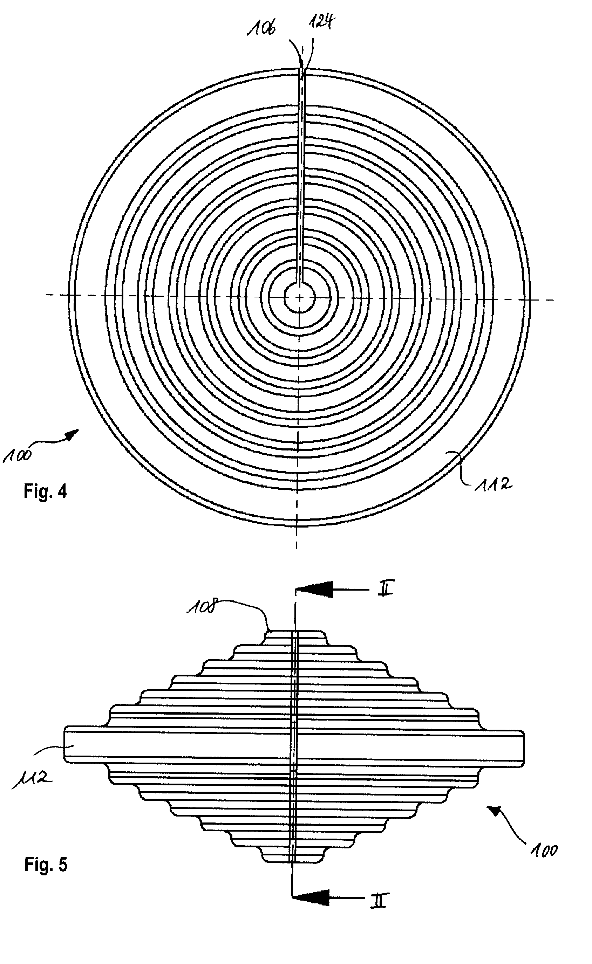

FIGs. 4 and 5 show top and side view of the sensor device according to FIG. 1. The circular symmetric from of the housing is advantageous for a lot of current detecting techniques. However, of course also other desired, preferable centrally symmetric footprints, such as polygonal or rectangular, can be envisaged if necessary. The dimensions of the slit 106 are of course also arbitrary design measures, as long as it is ensured that the cable or conduit to be monitored will be centered coaxially with the middle of the sensor device 100. The housing 102 may for instance be fabricated in a way that the sidewalls 124 of the slit 106 touch each other in the mounted state. The housing 102, as shown in FIG. 4, does not have any terminals leading outwards, for instance for transmitting a signal to a controller unit. Instead, the signal may be transmitted in a wireless manner. However, the device shown in FIGs. 1 to 5 may of course also be equipped with a terminal for electrically connecting same to a controller unit, a PC or the like.

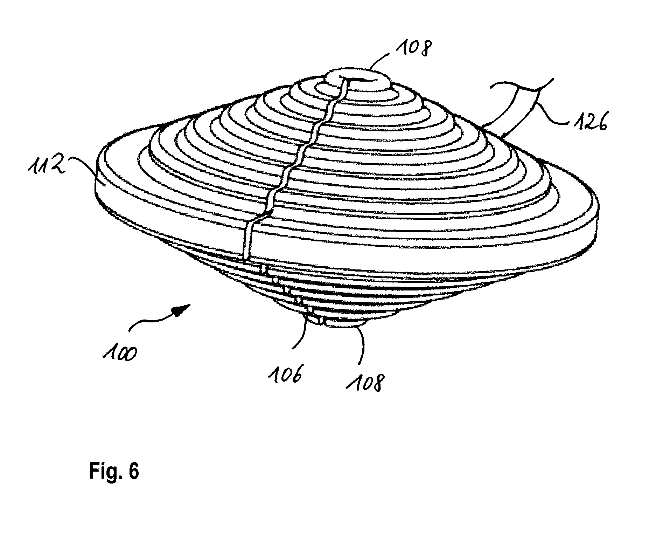

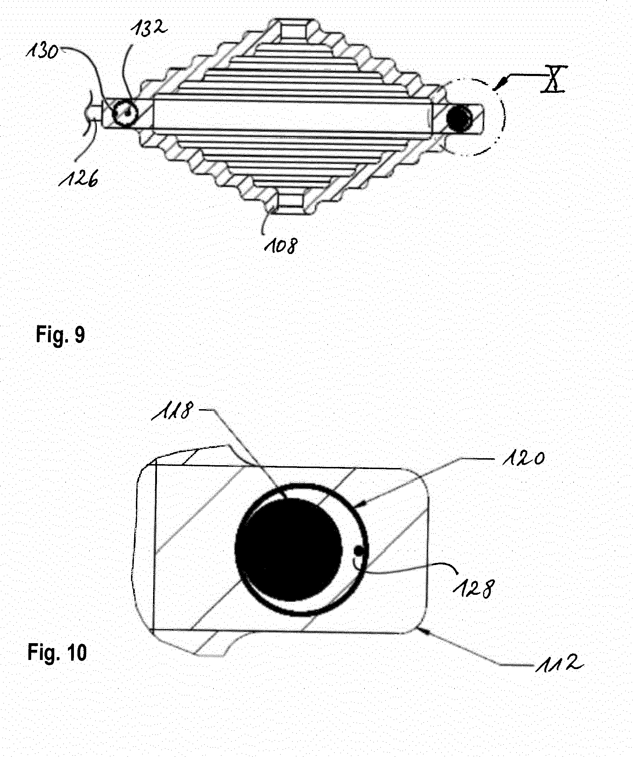

An advantageous embodiment of a sensor device having electrical leads for contacting the sensor elements is shown and explained with reference to FIGs. 6 to 10. Those parts that do not differ from the previous embodiment are not reiterated. The sensor device 100 according to FIGs. 6 and 7 comprises a cable leading to an external circuitry for processing the signals from the plurality of sensor elements. The cable 126 is connected, as shown in FIG. 7, to the first end of a first coil and the second end of a last coil in order to output a sensor signal to an external signal processing unit. The sensor device 100 thus represents a current sensing probe without any further intelligence integrated in the housing 102. However, although not shown in the figures, signal pre-processing electronic circuitry may also be integrated in the sensor device 100.

In the shown embodiment, a series of 16 RF chokes 118 are connected in series with each other, the first and the last one being arranged on the two opposing ends adjacent to the slit 106. Any other suitable number of chokes may of course also be used. The first and last wire 128, 130 of the series connection are led back in parallel to the chokes 118 and are connected to the cable 126 at a position opposite to the slit 106. The chokes and the wiring are encompassed by a shielding 120. As the dimensions of the chokes 118 are comparatively small with respect to the overall dimensions of the housing and by connecting the individual chokes 118 to each other via flexible wires 132, a sufficient flexibility and elasticity for opening the housing 102 can be ensured.

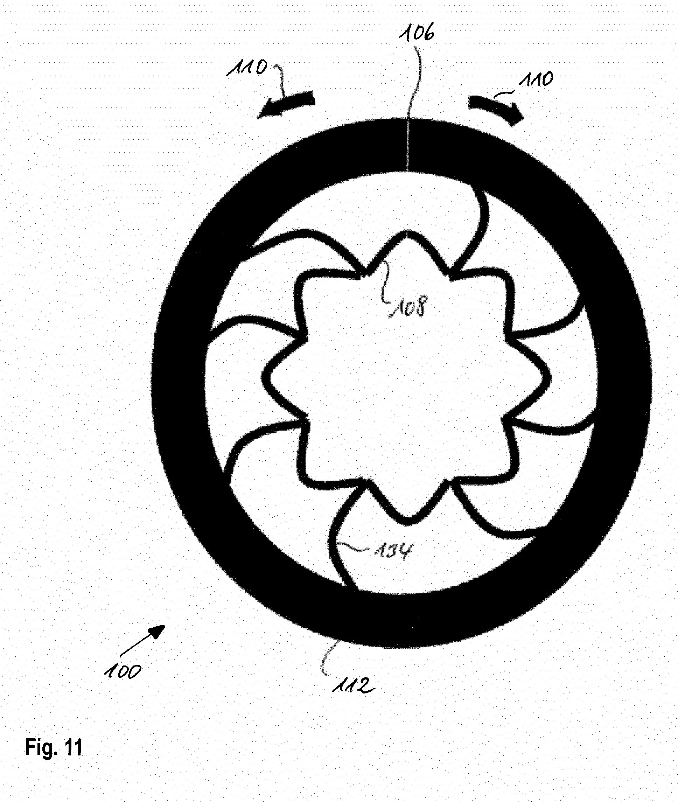

An alternative possibility of designing the mounting sleeve 108 is schematically shown in FIG. 11. Here, the sensor portion 112 is connected to only one mounting sleeve 108 by means of elastic lamellae 134. The mounting sleeve 108 is formed in a way that is has protrusions which are in contact with the cable. Again, a slit 106 allows opening the sensor device as a whole in directions 110 and the insertion of a cable in a position centrally to the sensor portion 112.

The sensor element according to the present invention may use a plurality of radio frequency chokes which have lacquered windings that are wrapped around a center core and are attached to an axial wire at either end. The flexible axial wire can be deformed when the housing 102 is opened. As shown in FIG. 7, the RF chokes are connected in series end to end and the last inductor is connected to a wire that leads back from the last inductor to an output cable and leading out.

A further possibility of connecting the coils to each other is to keep the windings which are wrapped around the core electrically separate from the core and from a center wire. This allows the larger core wires to be attached together in an electrical ring, thus having no break in the core/wire electrically and leading to a higher accuracy.

Compared to existing techniques, the sensor device according to the present invention has the following advantages: Firstly, it overcomes the inaccuracy of the centering of current measuring devices on cables, wherein the error is the smaller, the closer the axis of the cable is to the center of the sensor device. The installation is facilitated and the sensors, in particular cores of coils, are securely protected from moisture and damage. In comparison for instance to conventional Rogowski coils, the sensor device according to the present invention is very cost-effective.

Furthermore, a coded resistor can be included to identify which sensor is being used. The sensor device according to the present invention supports itself for clear viewing by a fault-finding electrician. When using RF chokes as described above, the cores are self-saturating and provide an inherent self-protection for very high-current situations. The grommet-shaped mounting sleeves provide a ready made cable measurement device for an electrician. In summary, any sort of sensor device, in particular a current measuring device, can be equipped with a very cost-effective means of measuring, in particular AC current.

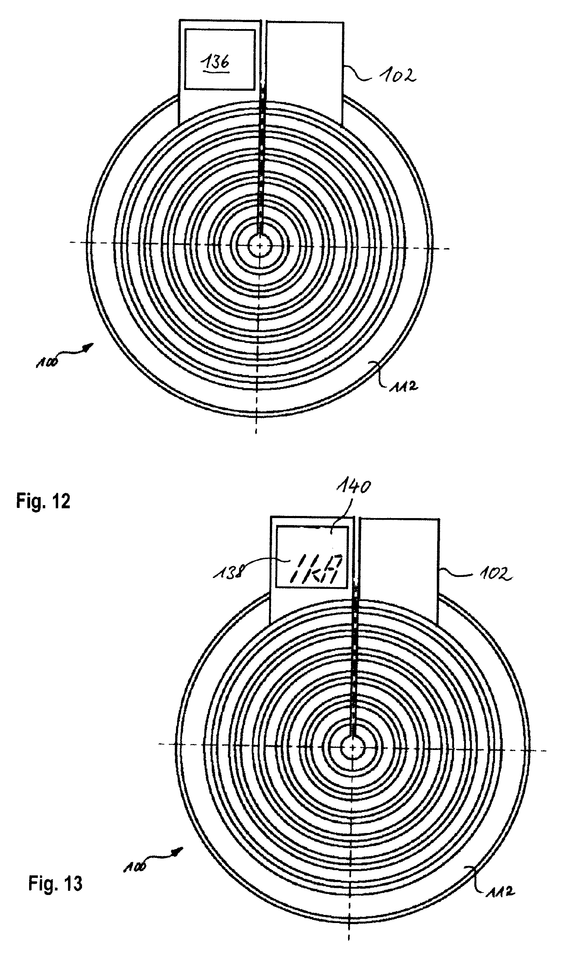

A further advantageous embodiment will be described now with reference to FIG. 12. According to this embodiment, within the housing 102 a further protrusion is created which encompasses an electronic integrator circuit 136. As the electrical output signal s(t) from the RF chokes is formed by the derivative of the actual current flowing through the cable being monitored with respect to time (s(t) = di/dt), the signal can be passed through an electronic integration circuit 136 for recovering the actual current wave form i(t). The electronic integrator circuit 136 may be powered externally or by a power source integrated within the sensor device 100. The electronic circuitry 136 is embedded into the molding compound of the housing 102 in a way that the output signal is a true current wave form.

FIG. 13 shows a further modification of the sensor device 100 according to the present invention. According to this embodiment, the protrusion of the housing 102 contains a complete electronic processing unit 138. In particular, the entire electronics required to measure and process the sensed current and/or voltage can be embedded by overmolding same when fabricating the sensor device according to the present invention. Furthermore, a display 140 can be provided for indicating a status of the cable to be measured to an operator. This display can for instance be a liquid crystal display, LCD.

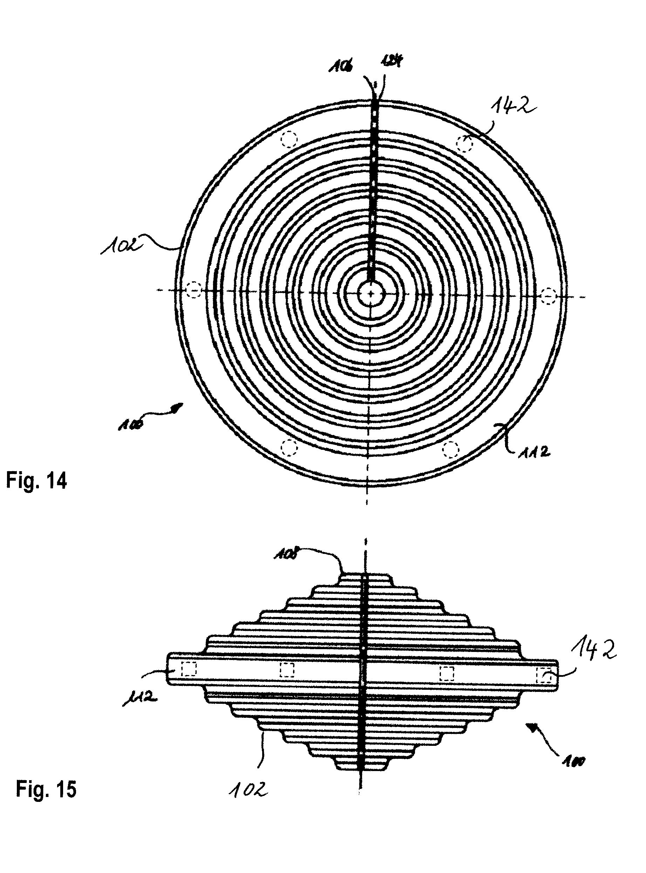

Alternatively, light emitting diodes, LED, 142 can be provided as this is shown as an example in figures 14 and 15. By embedding such optical indicators 142 into the housing, an observer can have a visual indication of the status of the conductor to be measured. For instance, LEDs 142 with differing colours can be provided in a housing 102 formed by a polyurethane resin. Of course, any sufficiently transparent material can be used for ensuring that the illumination of the visual indicators is visible to a service technician. These LEDs with differing colours would give the technician a quick information about the current passing through the conductor, for instance by defining that no colour means no current, that the green colour signifies a situation where the current is within the rated value, the amber colour signifies an elevated current level, and the red colour indicates to high a current. Additionally, also a flashing red colour could be used for identifying a fault condition existing on the cable. In FIGs 14 and 15 one possible implementation of LEDs 142 is shown, where the LEDs are embedded inside the sensor portion 112 of the sensor device 100 and are visible through the compound of the housing 102, thus giving a visual indication of the status and possible fault conditions of the cable to be monitored. Additionally or alternatively, of course also acoustic warning means may be embedded within the housing 102.

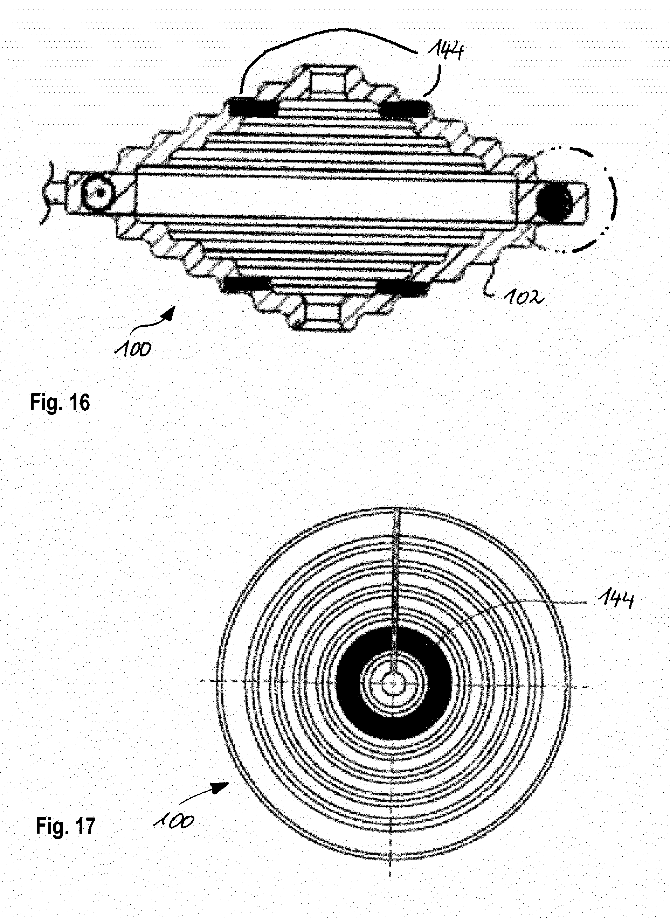

FIGs 16 and 17 illustrate an option for powering the sensors directly from the cable to be monitored. According to this embodiment, energy harvesting means 144 are embedded within the housing 102 for harvesting energy from the conductor the sensor device 100 is attached around. Energy harvesting coils may for instance be embedded into polyurethane resin in order to harvest power from the cable being sensed. As shown in FIG. 16 and 17, two flux concentrator type electronic units are provided for harvesting the power from the conductor and furthermore, an energy storage device can be included in the sensor device 100 which is charged by the energy harvesting units 144. Such an energy storage device can be formed by a battery and/or a supercapacitor (supercap).

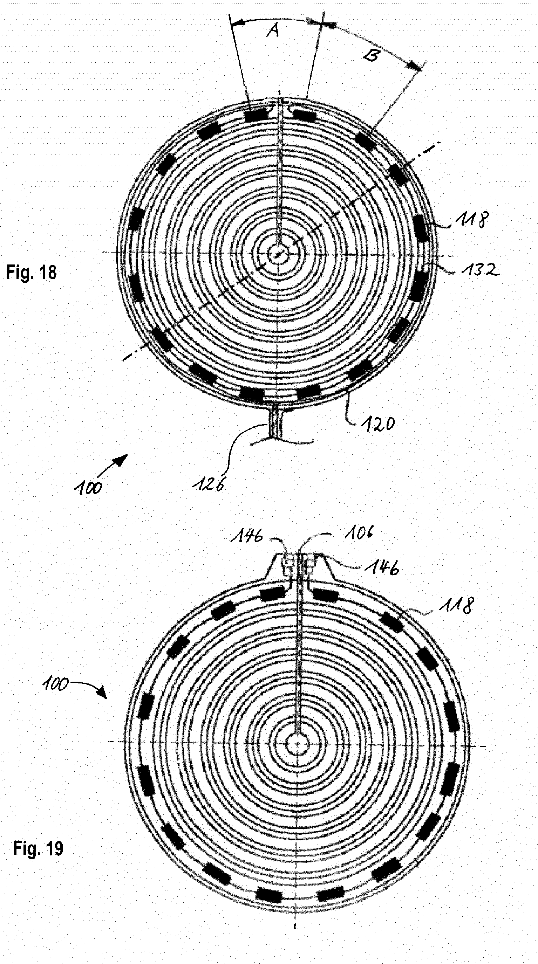

With respect to the arrangement of the RF chokes shown in FIG. 7, however, there exists a problem, as will be explained with reference to FIG. 18. In order to provide the best possible accuracy, the RF chokes 118 should be arranged in positions which are diagonally opposing each other. The number itself is not critical, but only the fact that there is a pairing of chokes 118, one directly across from the other. Moreover, the distances A and B, shown in FIG. 18, should be equal, so that the RF chokes 118 are uniformly distributed around the circumference of the sensor device 100.

In order to improve the arrangement of the RF chokes and to ensure equal distances A and B, a further embodiment is proposed and described with reference to FIG. 19. According to this embodiment, the wire is not brought back to exit on the opposite side of the slit 106 for inserting the cable, but is lead out where the slit 106 is provided at the mold. For instance, two mini banana plug receptacles 146 can be provided at each side of the slit 106 and be molded into the compound. The banana plug receptacles 146 are electrically connected with the two end chokes 118 and the top of the receptacles may be formed deeper than the mold surface, so that when the banana plugs are plugged into the receptacles 146, the compound extends over the plugs (not shown in the figure), thus providing a seal around the outside of the banana plug.

Furthermore, the electrical connector being plugged into the sensor device can additionally serve as the mechanical clip to bring the two faces of the slit together and thus hold the sensor device in place.

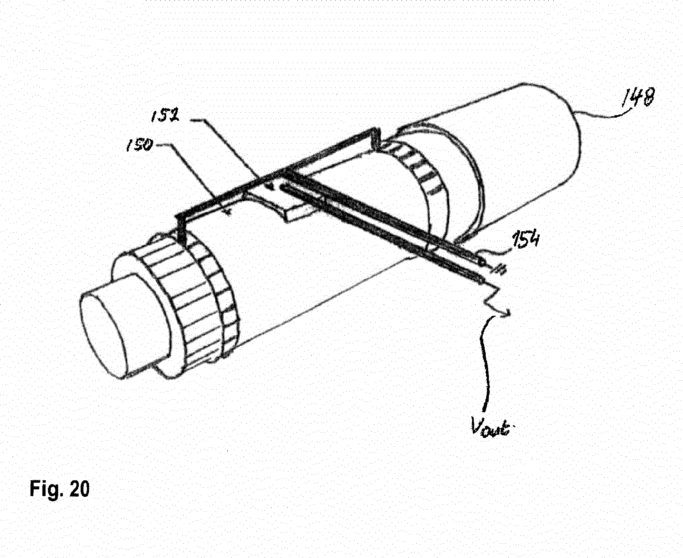

With respect to FIG. 20, the general principle of measuring a voltage of the cable will be explained. A cable 148 to be monitored usually comprises a semiconducting layer 150. A voltage plate 152 is provided in contact with the semiconductor material 150. The voltage plate 152 senses the voltage in the internal conductor with respect to ground 154 and the output signal Vₒᵤₜ indicates the voltage with respect to ground potential 154.

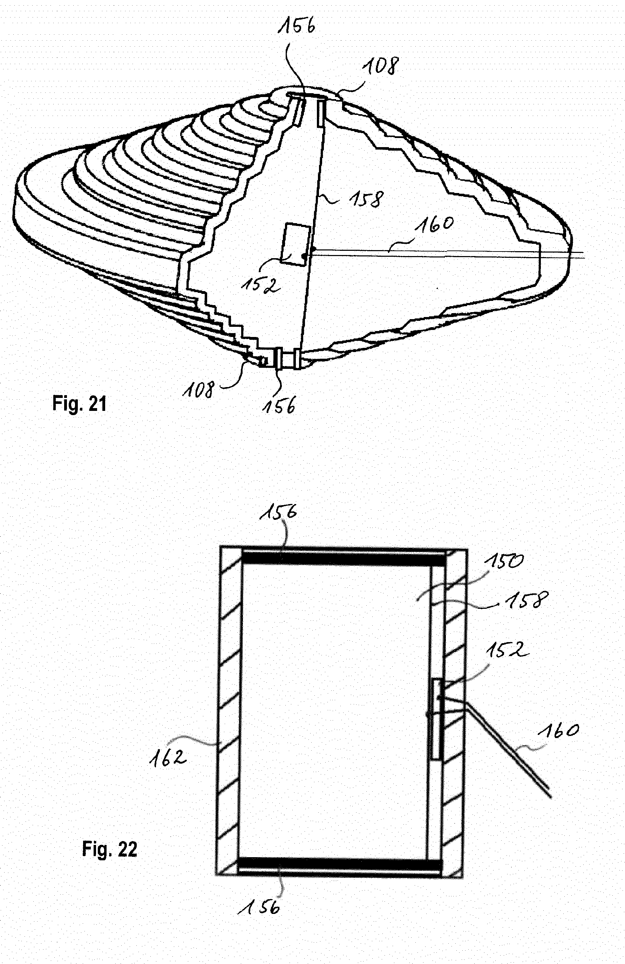

FIG. 21 shows an embodiment, where the sensor device 100 is equipped with a voltage sensor according to the principle of FIG. 20.

Here, a voltage sensor is embedded into the flexible multicore sensor device 100. The voltage sensor 152 is a conductor plate curving around the cable 148 being measured and is in contact with a semiconductor or insulation around the cable 148. The plate is held against the connector by the molding itself. Furthermore, two grounding rings 156 are provided at each of the mounting sleeves 108. These grounding rings 156 are electrically connected to each other by an insulated wire 158 running from one mounting sleeve 108 to the other. Furthermore, two wires 160 run across the axis of the cable and are connected to the exact center of the wire 158. As can be seen from FIG. 21, one of the wires 160 is connected to the ground wire 158 and the other is connected with the voltage plate 152. The two horizontal wires 160 can be formed as a twisted pair configuration which allows the sensing of the voltage while almost eliminating any induced currents.

FIG. 22 shows a voltage sensor that is provided separately from the sensor device 100 and can be combined therewith. In this figure, a strain relief sleeve 162 is inserted onto a high voltage cable and under an elbow molding of existing connectors. The voltage sensing plate 152 is arranged between the semicon material 150 of the cable and the strain relief sleeve 162. Two electrically conductive rings 156 at the top and bottom of the sleeve 162 provide an electrical connection with the exposed semiconductor layer 150 of the cable being sensed. The grounding rings 156 are electrically wired to each other by means of connection 158, and a tap is taken of the exact center point of this connection. The second tap is taken of the voltage sensing plate 152 as close to the grounding tap as physically possible. Output wires 160 lead from these tapping points to a measuring unit (not shown in the figure).

The configuration is designed to sense voltage and cancel out any induced current. The output wires 160 can of course also be formed in a twisted pair configuration in order to reduce current induction.

### REFERENCE NUMERALS

| **No.** | **Part** |
|---|---|
| 100 | sensor device |
| 102 | housing |
| 104 | sensor element |
| 106 | slit for inserting the cable |
| 108 | mounting sleeves |
| 110 | direction for opening the housing |
| 112 | sensor portion |
| 114 | bellows-shaped connection portion |
| 116 | middle axis |
| 118 | RF choke |
| 120 | shielding |
| 122 | inner surface of mounting sleeves |
| 124 | inner wall of slit |
| 126 | cable of sensor device |
| 128 | first wire |
| 130 | last wire |
| 132 | connecting wires |
| 134 | elastic lamella |
| 136 | electronic integrator circuit |
| 138 | electronic processing unit |
| 140 | optical display unit, LCD |
| 142 | light emitting diodes |
| 144 | energy harvesting unit |
| 146 | mini banana plug receptacles |
| 148 | cable to be monitored |
| 150 | semiconducting layer |
| 152 | voltage plate |
| 154 | ground |
| 156 | grounding rings |
| 158 | insulated wire |
| 160 | output wires |
| 162 | strain relief sleeve |

## Claims

1. Sensor device for being attached to a cable to be monitored, said sensor device (100) comprising:
at least one sensor element (104),
a housing (102) which at least partly encases said at least one sensor element (104) and which is configured to encompass the cable during a measurement process,
wherein said housing (102) is fabricated as a single part from a resilient electrically insulating material and is elastically deformable to be mounted over said cable.

2. Sensor device according to claim 1, wherein said sensor element (104) comprises at least two current measurement devices and/or at least one voltage measurement device.

3. Sensor device according to one of the preceding claims, wherein the housing has a ring-shaped sensor portion which accommodates the at least one sensor element (104).

4. Sensor device according to one of the preceding claims, wherein said housing has a substantially circular cross section with at least one mounting sleeve arranged centrally for fixing the sensor device over the cable.

5. Sensor device according to claim 3 or 4, wherein said housing has a slit-shaped opening (106) in order to leave in a radial direction an unobstructed gap for mounting said mounting sleeve on the cable.

6. Sensor device according to one of the claims 3 to 5, wherein said ring-shaped sensor portion is connected via at least one bellows-shaped connection portion to said at least one mounting sleeve.

7. Sensor device according to claim 6, wherein the sensor portion having a first inner diameter is connected with two mounting sleeves having a second inner diameter smaller than the first inner diameter, so that two bellows-shaped connection portions are provided which have in a longitudinal direction a stepwise changing inner diameter.

8. Sensor device according to one of the preceding claims, wherein said sensor element is formed by a plurality of RF choke coils connected in series.

9. Sensor device according to claim 8, wherein each RF choke is comprises a core and a wire wrapped thereon, wherein a second end of each RF choke wire is connected to a first end of the wire of a subsequent RF choke, the first end of the first choke and the second end of the last choke leading in parallel to the series of RF chokes to a terminal portion of said housing.

10. Sensor device according to claim 9, wherein said terminal portion is located in the same region as or in a diagonally opposing region of the slit-shaped opening (106) provided at the housing.

11. Sensor device according to one of the preceding claims, wherein said sensor element (104) comprises at least one of a current transformer, a Rogowski coil transformer, a magnetic field point sensor, a magnetic field line integral sensor, and a line integral optical current sensor.

12. Sensor device according to one of the preceding claims, wherein said housing (102) further encases an embedded electronic circuit, preferably an integrator circuit and/or a circuit carrier with a signal processing unit and/or an optical display unit which comprises a liquid crystal display, LCD, and/or a plurality of light emitting diodes, LED, for indicating a status of the sensor device.

13. Sensor device according to one of the preceding claims, wherein energy harvesting means are provided for harvesting energy from the cable whereto the sensor device (100) is attached and wherein said energy harvesting means comprise at least one coil connected to a flux concentrator unit and/or wherein energy storage means are embedded within the housing (102).

14. Method for fabricating a sensor device comprising the steps of:
providing at least one sensing element,
fabricating a housing which at least partly encases said at least one sensor element and which is configured to encompass the cable during a measurement process,
wherein said housing is fabricated as a single part from a resilient electrically insulating material and is elastically deformable to be mounted at said cable and wherein fabricating said housing comprises of overmoulding said at least two sensor elements and wherein said housing is fabricated from polyvinyl chloride (PVC), silicone rubber, Neoprene, Nitrile, ethylene propylene diene monomer (EPDM) rubber, or polyurethane.

15. Method of mounting a sensor device according to one of the claims 1 to 13 over a cable, comprising the steps of:
attaching the sensor device to the cable in a direction across to the longitudinal axis of the cable,
fixing the sensor device by plugging in an electrical connector which additionally serves as a mechanical clip to bring the two faces of the slit together and thus hold the sensor device in place.
